# EUROPÄISCHE PATENTANMELDUNG

(11) **EP 3 812 481 A1**
(43) Veröffentlichungstag der Anmeldung: **28.04.2021**
(21) Anmeldenummer: 19205377.5
(22) Anmeldetag: 25.10.2019
(51) Int. Cl.: C23C 14/24, C23C 14/52, C23C 14/54

(54) **VERDAMPFUNGSANORDNUNG, STEUERVORRICHTUNG UND VERFAHREN**

(71) Anmelder: VON ARDENNE Asset GmbH & Co. KG, 01328 Dresden (DE)
(72) Erfinder: GOTTSMANN, Lutz, 01900 Großröhrsdorf (DE); MELCHER, Jens, 01259 Dresden (DE)
(74) Vertreter: Viering, Jentschura & Partner mbB Patent- und Rechtsanwälte

(57) **Zusammenfassung**

Gemäß verschiedenen Ausführungsformen kann eine Verdampfungsanordnung (100 bis 400, 550) aufweisen: einen Verdampfungstiegel (102); einen Vorratstiegel (112), welcher mit dem Verdampfungstiegel (102) fluidleitend gekoppelt ist zum Austauschen eines zu verdampfenden Verdampfungsguts zwischen dem Vorratstiegel (112) und dem Verdampfungstiegel (102); eine Vakuumkammer (802), in welcher der Verdampfungstiegel (102) angeordnet ist, wobei der Vorratstiegel (112) außerhalb der Vakuumkammer (802) angeordnet ist.

## Beschreibung

Verschiedene Ausführungsbeispiele betreffen eine Verdampfungsanordnung, eine Steuervorrichtung und ein Verfahren.

Im Allgemeinen kann ein Substrat, beispielsweise ein Metallsubstrat bearbeitet (prozessiert), z.B. beschichtet werden, so dass die chemischen und/oder physikalischen Eigenschaften des Substrats verändert werden können. Um ein großflächiges Bearbeiten auf entsprechend großflächigen Substraten effizient zu realisieren, kann eine sogenannt In-Line-Anlage genutzt werden, bei der ein Substrat beispielsweise mittels Rollen durch die gesamte Anlage transportiert wird, wobei während des Transports des Substrats durch die In-Line-Anlage hindurch in einem oder mehreren Bereichen der In-Line-Anlage ein Beschichtungsprozess durchgeführt werden kann. Der Beschichtungsprozess kann beispielsweise erfolgen, indem ein Verdampfungsgut thermisch verdampft wird, und der Dampf auf dem Substrat abgeschieden wird.

Das Verdampfungsgut kann beispielsweise derart eingerichtet sein, dass es das Substrat passiviert (d.h. reaktionsträge macht). Ein Beispiel hierfür ist beispielsweise das sogenannte Verzinken, bei dem Zink auf das Substrat aufgebracht wird.

Herkömmlicherweise erfolgt das Verzinken mittels einer Feuerverzinkung. Dieses ist aufgrund der hohen Prozesstemperatur (ca. 450°C) nicht für moderne höherfeste Stähle geeignet, da das Substrat bei diesen Temperaturen seine Festigkeit verliert. Alternativ erfolgt das Verzinken mittels einer physikalischen Gasphasenabscheidung (PVD), welche allerdings nicht großtechnisch und flächendeckend etabliert ist, beispielsweise aufgrund der geringen Standzeit und der sich mit dem Materialverbrauch verändernden Gasphasenbildung. Alternativ erfolgt das Verzinken mittels einer galvanischen Verzinkung, welche allerdings teuer ist und hohe Anforderung an den Umweltschutz nicht erfüllt.

Gemäß verschiedenen Ausführungsformen werden eine Verdampfungsanordnung, eine Steuervorrichtung und ein Verfahren (beispielsweise zum Durchführen einer physikalischen Gasphasenabscheidung) bereitgestellt, welche eine größere Standzeit bereitstellen, eine zeitstabilere Gasphasenbildung bereitstellen, umweltverträglich sind und/oder kostengünstiger sind. Beispielsweise wird ein Verdampfen von Metallen im Vakuum bereitgestellt das konzeptionell für Produktionsanlagen geeignet ist, und kontinuierlich über mehrere Tage bzw. Wochen funktioniert.

Gemäß verschiedenen Ausführungsformen kann eine Verdampfungsanordnung aufweisen: einen Verdampfungstiegel; einen Vorratstiegel, welcher mit dem Verdampfungstiegel fluidleitend gekoppelt ist zum Austauschen eines zu verdampfenden Verdampfungsguts zwischen dem Vorratstiegel und dem Verdampfungstiegel; eine Vakuumkammer, in welcher der Verdampfungstiegel angeordnet ist, wobei der Vorratstiegel außerhalb der Vakuumkammer angeordnet ist.

Anschaulich wird der Verdampfungstiegel (auch als Verdampfer bezeichnet) in der Vakuumkammer angeordnet und verbunden mit dem Vorratstiegel über eine beheizbare Rohrleitung (z.B. eine kommunizierende Röhre). Der Vorratstiegel kann optional in einer weiteren Kammer (auch als Druckkammer bezeichnet) angeordnet sein oder werden.

Mittels einer Materialnachfüllungsvorrichtung (die eine Chargiervorrichtung aufweist), welche optional über ein Ventil mit der Druckkammer verbunden ist, kann das verbrauchte Verdampfungsgut nachgefüllt werden (auch als Nachfüllen, Beschicken oder Chargieren bezeichnet). Optional kann der Vorratstiegel eingerichtet sein festes Verdampfungsgut zu schmelzen (dann auch als Schmelztiegel bezeichnet). Die Druckkammer und/oder eine Kammer der Materialnachfüllungsvorrichtung können derart eingerichtet sein, dass innerhalb dieser wahlweise ein Gasunterdruck oder ein Gasüberdruck (z.B. bis ca. 100 mbar über Normaldruck) erzeugt werden kann.

Es zeigen
- Figuren 1 bis 4: jeweils eine Verdampfungsanordnung gemäß verschiedenen Ausführungsformen in verschiedenen Ansichten.
- Figur 5: Prozessieranordnung gemäß verschiedenen Ausführungsformen in einer schematischen Seitenansicht oder Querschnittsansicht;
- Figur 6A bis 6D, 7A und 7B: jeweils eine Verdampfungsanordnung gemäß verschiedenen Ausführungsformen in einer schematischen Seitenansicht oder Querschnittsansicht in einem Verfahren gemäß verschiedenen Ausführungsformen; und
- Figur 8: einen Füllstand-Regelmechanismus gemäß verschiedenen Ausführungsformen in einem Regeldiagramm.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung (z.B. fluidleitfähigen Verbindung), eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

Gemäß verschiedenen Ausführungsformen kann der Begriff "gekoppelt" oder "Kopplung" im Sinne einer (z.B. mechanischen, hydrostatischen, thermischen und/oder elektrischen), z.B. direkten oder indirekten, Verbindung und/oder Wechselwirkung verstanden werden. Mehrere Elemente können beispielsweise entlang einer Wechselwirkungskette miteinander gekoppelt sein, entlang welcher die Wechselwirkung (z.B. ein Material) übertragen werden kann. Beispielsweise können zwei miteinander gekoppelte Elemente eine Wechselwirkung miteinander austauschen, z.B. eine mechanische, hydrostatische, thermische und/oder elektrische Wechselwirkung. Gemäß verschiedenen Ausführungsformen kann "gekuppelt" im Sinne einer mechanischen (z.B. körperlichen bzw. physikalischen) Kopplung verstanden werden, z.B. mittels eines direkten körperlichen Kontakts. Eine Kupplung kann eingerichtet sein, eine mechanische Wechselwirkung (z.B. Kraft, Drehmoment, etc.) zu übertragen.

Als Steuern kann eine beabsichtigte Beeinflussung eines Systems verstanden werden. Dabei kann der momentane Zustand des Systems (auch als Ist-Zustand bezeichnet) gemäß einer Vorgabe (auch als Soll-Zustand bezeichnet) verändert werden. Regeln kann als Steuern verstanden werden, wobei zusätzlich einer Zustandsänderung des Systems durch Störungen entgegengewirkt wird. Anschaulich kann die Steuerung eine nach vorn gerichtete Steuerstrecke aufweisen und somit anschaulich eine Ablaufsteuerung implementieren, welche eine Eingangsgröße (z.B. die Vorgabe) in eine Ausgangsgröße umsetzt. Die Steuerstrecke kann aber auch Teil eines Regelkreises sein, so dass eine Regelung implementiert wird. Die Regelung weist im Gegensatz zu der reinen vorwärts gerichteten Ablaufsteuerung eine fortlaufende Einflussnahme der Ausgangsgröße auf die Eingangsgröße auf, welche durch den Regelkreis bewirkt wird (Rückführung). Mit anderen Worten kann alternativ oder zusätzlich zu der Steuerung eine Regelung verwendet werden bzw. alternativ oder zusätzlich zu dem Steuern ein Regeln erfolgen. Der Zustand des Systems (auch als Arbeitspunkt bezeichnet) kann von einer oder mehr als einer Regelgröße des Systems repräsentiert werden, deren Ist-Wert den Ist-Zustand des Systems und deren Soll-Wert (auch als Führungswert bezeichnet) den Soll-Zustand des Systems repräsentiert. Bei einer Regelung wird ein Ist-Zustand des Systems (z.B. basierend auf einer Messung ermittelt) mit dem Soll-Zustand des Systems verglichen und die eine oder mehr als eine Regelgröße mittels einer entsprechenden Stellgröße (unter Verwendung eines Stellglieds) derart beeinflusst, dass die Abweichung des Ist-Zustands von dem Soll-Zustand des Systems verringert (z.B. minimiert) wird.

Der Verdampfer kann in einer Vakuumkammer (auch als Beschichtungskammer bezeichnet, wenn in dieser auch beschichtet wird) angeordnet sein. Der Verdampfer kann eine geschlossene Einheit sein, welche beheizbar ist. Die Einheit weist mindestens zwei Öffnungen auf, z.B. eine Anschlussöffnung für die Fluidleitung (z.B. eine Flüssigmetallleitung) und eine Anschlussöffnung zur Ableitung des Metalldampfes zum Substrat hin. Das eigentliche Bedampfen des Substrates kann in einem sich anschließenden geheizten Kanal erfolgen, in welchem der Beschichtungsbereich angeordnet ist.

Der Vorratstiegel kann optional in einer anderen Kammer (auch als Tiegelkammer oder erste Druckkammer bezeichnet) angeordnet sein. Der Vorratstiegel ist beheizbar und weist mindestens zwei Öffnungen auf, z.B. eine Anschlussöffnung für die Fluidleitung (z.B. eine Flüssigmetallleitung) und eine Öffnung zum Zuführen (auch als Chargieren bezeichnet) von Verdampfungsgut. Ein entnehmbarer oberer Kammerdeckel kann Wartungsarbeiten erleichtern.

Die Chargiervorrichtung kann optional in einer noch anderen Kammer (auch als Chargierkammer bezeichnet) angeordnet sein. Die Chargierkammer kann mit einem vakuumdichten Ventil (auch als Chargierventil bezeichnet) mit der Tiegelkammer verbunden sein. Die Chargiervorrichtung kann zyklisch mit Verdampfungsmaterial befüllt werden. Danach kann die Chargiervorrichtung linear durch das geöffnete Chargierventil bewegt werden und den Verdampfer mit neuem Verdampfungsgut auffüllen. Je nach Konfiguration kann die Chargiervorrichtung flüssiges oder festes Verdampfungsmaterial aufnehmen, zum Vorratstiegel befördern und dort übergeben.

Die Flüssigmetallleitung verbindet den Vorratstiegel mit dem Verdampfer. Die Flüssigmetallleitung ist geheizt und wird vakuumdicht von der Tiegelkammer zur Atmosphäre und ebenso vakuumdicht von Atmosphäre in die Vakuumkammer geführt.

Das Betreiben der Verdampfungsanordnung kann in einer Phase zum Vorbereiten aufweisen: Evakuieren der Beschichtungskammer, wobei der Verdampfer kalt und leer ist, der Vorratstiegel kalt und befüllt mit Verdampfungsgut ist, das Chargierventil geschlossen ist, die Flüssigmetallleitung kalt und leer ist, und die Vakuumkammer und Tiegelkammer gleichzeitig evakuiert werden.

Das Betreiben der Verdampfungsanordnung kann in einer Phase zum Konditionieren aufweisen: Beheizen des Verdampfers, Beheizen der Flüssigmetallleitung, Beheizen des Vorratstiegels bis das gesamte Verdampfungsgut darin aufgeschmolzen ist, Füllen der heißen Flüssigmetallleitung mit flüssigem Verdampfungsgut (vereinfacht auch als Schmelze bezeichnet), Belüften der Tiegelkammer und Bringen auf einen Überdruck (z.B. mit ungefähr 50 mbar über Atmosphärendruck) mittels eines Inertgases (auch als Druckbeaufschlagen bezeichnet), so dass das Verdampfungsgut durch eine Druckdifferenz bis in den nunmehr geheizten Verdampfer fließt und darin aufsteigt, wobei das Chargierventil permanent geschlossen bleibt.

Das Betreiben der Verdampfungsanordnung kann in einer Phase zum Verdampfen aufweisen: dass der Verdampfer heiß ist, dass die Flüssigmetallleitung heiß und gefüllt ist, dass der Vorratstiegel heiß und gefüllt ist, dass die Tiegelkammer mit ungefähr 50 mbar Überdruck eines Inertgases druckbeaufschlagt ist, dass das im Verdampfer verdampfende Material (ohne Eingreifen des Füllstand-Regelmechanismus) den Badspiegel sowohl vom Verdampfer als auch vom Vorratstiegel senkt; dass das Senken mittels kontinuierlicher Druckerhöhung in der Tiegelkammer (z.B. bis ca. 100 mbar Überdruck eines Inertgases) kompensiert wird, was den Badspiegel im Vorratstiegel (auch als Vorratsspiegel bezeichnet) absenkt bzw. im Verdampfer stabilisiert, z.B. im Vorratstiegel bis zu einer vorgegebenen Mindestfüllhöhe, und dass danach eine Phase zum Nachfüllen anschließt.

Das Betreiben der Verdampfungsanordnung kann in der Phase zum Nachfüllen aufweisen: dass die Chargierkammer mit dem gleichen Überdruck eines Inertgases wie die Tiegelkammer druckbeaufschlagt wird, dass das Chargierventil geöffnet wird, dass die Chargiervorrichtung zum Vorratstiegel fährt, neues Verdampfungsmaterial in den Vorratstiegel füllt, und anschließend zurück fährt, dass das Chargierventil wieder geschlossen wird, dass durch das Nachfüllen der Badspiegel im Vorratstiegel wie auch (ohne Eingreifen des Füllstand-Regelmechanismus) der Badspiegel im Verdampfer steigt.

Dem Anstieg des Badspiegels im Verdampfer kann mit einer oder mehr als einer der folgenden Maßnahmen entgegengewirkt werden: Absenken des Überdrucks in dem Vorratstiegel bzw. der Tiegelkammer; und/oder dass das Verhältnis zwischen dem Innenraumquerschnitt des Vorratstiegels und dem Innenraumquerschnitt des Verdampfers größer ist als 1 (z.B. ideal in einem Bereich von ungefähr 2 bis ungefähr 5). Letzteres erreicht, dass eine Höhenänderung des Badspiegels im Verdampfer geringer ist als im Vorratstiegel. Der Innenraumquerschnitt kann im Wesentlichen parallel zu dem Badspiegel gemessen werden.

Gemäß verschiedenen Ausführungsformen werden bereitgestellt: eine beheizte, kommunizierende Röhre, die vakuumdicht in eine oder mehr als eine Kammer geführt ist; ein Überdruck in der Tiegelkammer verändert die Höhe des Badspiegels im Verdampfer, das Innenraumquerschnittsverhältnis (Vorratstiegel zu Verdampfer) kann größer sein als 1, ein automatisches Einstellen der Höhe des Badspiegels im Verdampfer bei Evakuierung; ein automatisches Absenken des Badspiegels im Verdampfer bei Belüftung; eine Messung der Höhe des Badspiegels im Verdampfer zur Steuerung und/oder Regelung der Verdampfungsrate; und/oder eine Temperaturmessung im Verdampfer zur Steuerung und/oder Regelung der Verdampfungsrate.

Gemäß verschiedenen Ausführungsformen kann mittels des verdampften Verdampfungsguts ein Beschichten von Stahlblech mit einem korrosionsresistenten Material erfolgen, z.B. mit Zink als Verdampfungsgut.

Allgemeiner gesprochen kann auch ein anderes Material (auch als Verdampfungsgut bezeichnet) verdampft werden. Das Verdampfungsgut kann beispielsweise Kupfer (Cu), Silber (Ag), Zinn (Sn), Zink (Zn), Indium (In) und/oder Gold (Au) aufweisen oder daraus gebildet sein. Beispielsweise kann ein solches Verdampfungsgut andere edle metallische Verbindungen und Legierungen von beispielsweise Kupfer (Cu), Silber (Ag), Zinn (Sn), Indium (In) und/oder Gold (Au) aufweisen oder daraus gebildet sein. Prinzipiell können aber auch andere Arten von Verdampfungsgut verdampft werden, z.B. ein oder mehr als ein Metall. Wird mit dem Dampf des Verdampfungsguts ein Substrat beschichtet, wird dieses auch als Beschichtungsmaterial bezeichnet.

Im Rahmen dieser Beschreibung kann ein Metall (auch als metallischer Werkstoff bezeichnet) zumindest ein metallisches Element (d.h. ein oder mehrere metallische Elemente) aufweisen (oder daraus gebildet sein), z.B. zumindest ein Element aus der Folgenden Gruppe von Elementen: Kupfer (Cu), Eisen (Fe), Titan (Ti), Nickel (Ni), Silber (Ag), Chrom (Cr), Platin (Pt), Gold (Au), Magnesium (Mg), Aluminium (Al), Zirkonium (Zr), Tantal (Ta), Molybdän (Mo), Wolfram (W), Vanadium (V), Barium (Ba), Indium (In), Calcium (Ca), Hafnium (Hf), Samarium (Sm), Silber (Ag), und/oder Lithium (Li). Ferner kann ein Metall eine metallische Verbindung (z.B. eine intermetallische Verbindung oder eine Legierung) aufweisen oder daraus gebildet sein, z.B. eine Verbindung aus zumindest zwei metallischen Elementen (z.B. aus der Gruppe von Elementen), wie z.B. Bronze oder Messing, oder z.B. eine Verbindung aus zumindest einem metallischen Element (z.B. aus der Gruppe von Elementen) und mindestens einem nichtmetallischen Element (z.B. Kohlenstoff), wie z.B. Stahl.

Das verdampfte Verdampfungsgut kann an einem Substrat angelagert werden und dort eine Schicht bilden (auch als Beschichten des Substrats bezeichnet). Die Schicht kann dann das Verdampfungsgut, z.B. dessen chemische Zusammensetzung, aufweisen oder daraus gebildet sein.

Gemäß verschiedenen Ausführungsformen kann das Substrat zumindest eines von Folgendem aufweisen oder daraus gebildet sein: eine Keramik, ein Glas, einen Halbleiter (z.B. einen amorphen, polykristallinen oder einkristallinen Halbleiter, z.B. Silizium), ein Metall (z.B. Aluminium, Kupfer, Eisen, Stahl, Platin, Gold, etc.), ein Polymer (z.B. Kunststoff) und/oder eine Mischung verschiedener Materialien, wie z.B. ein Verbundwerkstoff (z.B. Kohlenstofffaser-verstärkter-Kohlenstoff, oder Kohlenstofffaser-verstärkter-Kunststoff). Das Substrat kann als Platte oder als Band (z.B. eine Folie) bereitgestellt sein oder werden. Beispielsweise kann das Substrat eine Kunststofffolie, eine Halbleiterfolie, eine Metallfolie und/oder eine Glasfolie aufweisen oder daraus gebildet sein, und optional beschichtet sein oder werden. Alternativ oder zusätzlich kann das Substrat beispielsweise Fasern aufweisen, z.B. Glasfasern, Kohlenstofffasern, Metallfasern und/oder Kunststofffasern, z.B. in Form eines Gewebes, eines Netzes, eines Gewirks, Gestricks oder als Filz bzw. Flies.

Gemäß verschiedenen Ausführungsformen kann als Tiegel ein hochtemperaturfester Behälter verstanden werden, der eingerichtet ist, darin ein Verdampfungsgut zu verdampfen, d.h. in den gasförmigen Zustand zu überführen. Das Verdampfungsgut kann in dem Tiegel als Schmelze (d.h. in flüssigem Zustand bzw. in geschmolzener Form) angeordnet sein, welche das gasförmige Verdampfungsgut abgibt. Das Schmelzen des Verdampfungsguts kann im Allgemeinen verstanden werden als das Überführen des Verdampfungsguts von dem festen Zustand (auch als fester Aggregatszustand bezeichnet) in den flüssigen Zustand. Das Verdampfen des Verdampfungsguts kann im Allgemeinen verstanden werden als das Überführen des Verdampfungsguts von dem flüssigen Zustand (die sogenannte Schmelze) in den gasförmigen Zustand (den sogenannten Dampf).

Ein Tiegel kann im Allgemeinen eine Tiegelwanne aufweisen, welche einen Hohlraum (das sogenannte Tiegelinnere) aufweist, in welchem das (z.B. feste und/oder flüssige) Verdampfungsgut aufgenommen werden kann. Die obere Öffnung (auch als Tiegelöffnung bezeichnet) der Tiegelwanne, welche das Tiegelinnere freilegt, kann bei einem Verdampfungstiegel als Dampfaustrittsöffnung verwendet werden. Das Tiegelinnere kann sich von der Tiegelöffnung aus in den Körper der Tiegelwanne hineinerstrecken entlang einer Richtung, die im Betrieb des Tiegels parallel zu der Gravitationsrichtung ist. Das Tiegelinnere kann eine Querschnittsfläche (auch als Innenraumquerschnitt bezeichnet) aufweisen, welche quer zu der Richtung ist und im Betrieb des Tiegels im Wesentlichen der Größe der Fläche des Badspiegels entspricht.

Das in dem Tiegelinneren des Verdampfungstiegels verdampfte Verdampfungsgut kann als Dampf aus der Dampfaustrittsöffnung heraus strömen. Bei einem Vorratstiegel kann durch die obere Öffnung (dann auch als Materialzuführöffnung bezeichnet) der Tiegelwanne hindurch dem Tiegelinneren das Verdampfungsgut zugeführt werden, z.B. in fester oder flüssiger Form. Der Vorratstiegel wird beispielsweise genutzt, um das Verdampfungsgut zu schmelzen (dann auch als Schmelztiegel bezeichnet), wobei die daraus entstehende Schmelze dann vorgehalten und bei Bedarf dem Verdampfungstiegel zugeführt werden kann.

Optional kann der Tiegel eine die Tiegelwanne umgebende Abschirmung aufweisen, welche das Abstrahlen thermischer Energie von der Tiegelwanne hemmt. Optional kann der Tiegel einen Deckel (auch als Tiegeldeckel bezeichnet) aufweisen, welche die Dampfaustrittsöffnung verschließt, z.B. luftdicht (d.h. hermetisch).

Der Tiegel, oder zumindest die das Tiegelinnere begrenzenden Tiegelwände (z.B. auch der Tiegeldeckel), können ein hochtemperaturfestes Material aufweisen oder daraus gebildet sein. Ein hochtemperaturfestes Objekt (z.B. Körper oder Material) kann beispielsweise einen Transformationsbereich (z.B. Schmelzpunkt oder Glasübergangstemperatur) vom festen Zustand in einen viskosen (z.B. flüssigen) Zustand von mehr als ungefähr 1000°C aufweisen, z.B. mehr als ungefähr 1500°C. Bezüglich des Verdampfungsguts kann der Transformationsbereich zumindest größer sein als die Verdampfungstemperatur des Verdampfungsguts. Das hochtemperaturfeste Material kann beispielsweise ein Dielektrikum sein, wie beispielsweise Quarzglas oder Keramik (z.B. ein Oxid, ein Nitrid und/oder ein Karbid aufweisend). Das hochtemperaturfeste Material kann beispielsweise Graphit sein. Das hochtemperaturfeste Material kann beispielsweise ein Metall aufweisen oder daraus gebildet sein, z.B. Wolfram oder Stahl. Es können auch mehrere verschiedene hochtemperaturfeste Materialien verwendet werden. Optional kann das hochtemperaturfeste Material chemisch inert sein, z.B. gegenüber Sauerstoff und/oder gegenüber der Schmelze.

Im Folgenden werden verschiedene Schritte und Einzelheiten zu einem Betrieb der Verdampfungsanordnung beschrieben. Es kann verstanden werden, dass das Beschriebene (z.B. einzelne Schritte oder Phasen des Betriebs) in Analogie mittels Hardware (wie z.B. eines hartverschalteten Schaltkreises) und/oder Software (z.B. Codesegmente oder einer ganzen Anwendung) implementiert werden kann. Beispielsweise kann eine Anwendung (auch als Programm bezeichnet) bereitgestellt sein oder werden, die entsprechende Codesegmente (z.B. Programmcode) aufweist, und die auf einem Prozessor und/oder mittels eines Schaltkreises, der den Prozessor aufweist, ausgeführt sein oder werden kann.

Der Begriff "Prozessor" kann als jede Art von Entität verstanden werden, die die Verarbeitung von Daten oder Signalen erlaubt. Die Daten oder Signale können beispielsweise gemäß zumindest einer (d.h. einer oder mehr als einer) spezifischen Funktion behandelt werden, die vom Prozessor ausgeführt wird. Ein Prozessor kann eine analoge Schaltung, eine digitale Schaltung, eine Mischsignalschaltung, eine Logikschaltung, einen Mikroprozessor, eine zentrale Verarbeitungseinheit (CPU), eine Grafikverarbeitungseinheit (GPU), einen digitalen Signalprozessor (DSP), eine programmierbare Gatter-Anordnung (FPGA), eine integrierte Schaltung oder eine beliebige Kombination davon aufweisen oder daraus gebildet sein. Jede andere Art der Implementierung der jeweiligen Funktionen, die nachstehend ausführlicher beschrieben werden, kann auch als Prozessor oder Logikschaltung verstanden werden. Es versteht sich, dass einer oder mehrere der hierin detailliert beschriebenen Verfahrensschritte von einem Prozessor ausgeführt (z.B. realisiert) werden können, durch eine oder mehrere spezifische Funktionen, die von dem Prozessor ausgeführt werden.

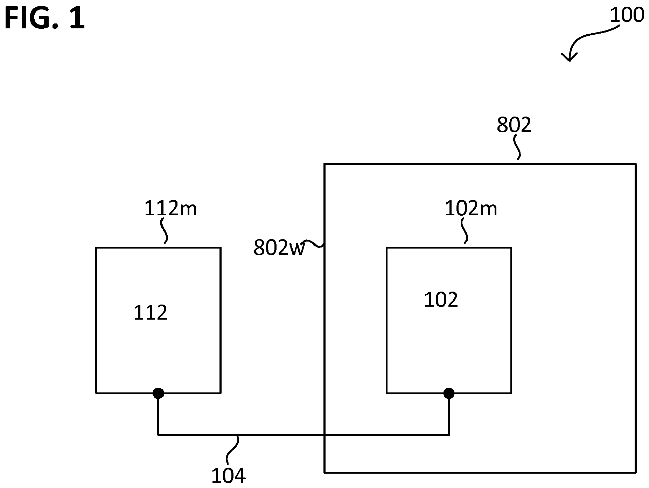

**Fig.1** veranschaulicht eine Verdampfungsanordnung 100 gemäß verschiedenen Ausführungsformen in einer schematischen Seitenansicht oder Querschnittsansicht. Die Verdampfungsanordnung 100 weist einen Verdampfungstiegel 102 (auch als erster Tiegel 102 oder Primärtiegel bezeichnet) und einen Vorratstiegel 112 (auch als zweiter Tiegel 102 oder Versorgungstiegel bezeichnet) auf, welche fluidleitend miteinander gekoppelt sind, z.B. mittels einer Fluidleitung 104. Die Verdampfungsanordnung 100 weist eine Vakuumkammer 802 auf, in welcher der Verdampfungstiegel 102 angeordnet ist. Der Vorratstiegel 112 kann außerhalb (z.B. neben) der Vakuumkammer 802 angeordnet sein. Beispielsweise kann die Vakuumkammer 802 eine Kammerwand 802w aufweisen, welche den Vorratstiegel 112 von dem Verdampfungstiegel 102 räumlich separiert. Beispielsweise kann die Fluidleitung 104 durch die Kammerwand 802w hindurchgeführt sein.

Gemäß verschiedenen Ausführungsformen kann die Vakuumkammer mittels eines Kammergehäuses bereitgestellt sein oder werden, in dem eine oder mehr als eine Vakuumkammer bereitgestellt sein kann. Mehrere Vakuumkammern in einem Kammergehäuse können auch als Kompartments bezeichnet werden. Jede Vakuumkammer kann optional eine Öffnung aufweisen, welche mittels eines Kammerdeckels verschlossen ist. Das oder jedes Kammergehäuse kann beispielsweise stirnseitig (z.B. eingangsseitig und/oder ausgangsseitig jeweils) einen Kammerflansch aufweisen, mittels dessen zwei Kammergehäuse miteinander verbunden werden können. Die oder jede Vakuumkammer in einem Kammergehäuse kann zwischen den zwei Kammerflanschen des Kammergehäuses angeordnet sein.

Das für die Vakuumkammer Beschriebene kann allgemeiner gesprochen in Analogie für eine Druckkammer (vereinfacht hierin auch als Kammer bezeichnet) gelten. Eine Druckkammer (bzw. das Kammergehäuse) kann derart eingerichtet sein, dass darin ein Überdruck (dann auch als Überdruckkammer bezeichnet) und/oder ein Unterdruck (dann auch als Unterdruckkammer bezeichnet), z.B. ein Vakuum (dann auch als Vakuumkammer bezeichnet), bereitgestellt werden kann. In der Regel sind die Dichtungen und Verbindungen einer Druckkammer nur für eine der beiden Druckbereiche ausgelegt, so dass eine Vakuumkammer beschädigt oder geöffnet wird, wenn darin ein Überdruck herrscht, bzw. eine Überdruckkammer beschädigt oder geöffnet wird, wenn darin ein Unterdruck herrscht. Gemäß verschiedenen Ausführungsformen kann eine Druckkammer als Unterdruckkammer und als Überdruckkammer (d.h. zur Verwendung in beiden Druckbereichen) eingerichtet sein, z.B. innerhalb eines Druckkörpers als Kammergehäuse. Ein Überdruck kann größer sein als der Atmosphärendruck und ein Unterdruck kann kleiner als der Atmosphärendruck. Der Atmosphärendruck kann der auf die Erdoberfläche (oder den jeweiligen Untergrund, auf dem die Verdampfungsanordnung steht) einwirkende Luftdruck sein, der durch die Gewichtskraft der Luftsäule über der Verdampfungsanordnung entsteht. Der Atmosphärendruck kann zeitlichen oder örtlichen Schwankungen unterliegen und vom Normaldruck (1,01325 bar) abweichen.

Ein Kammergehäuse kann beispielsweise gegenüber einem Druckunterschied stabil eingerichtet sein, z.B. derart stabil eingerichtet sein, dass diese dem Einwirken des Atmosphärendrucks im abgepumpten Zustand standhält. Der oder jeder Kammer des Kammergehäuses kann mittels einer Pumpenanordnung (z.B. aufweisend zumindest eine Vakuumpumpe, z.B. eine Hochvakuumpumpe, z.B. eine Turbomolekularpumpe) Gas entzogen werden und/oder mittels einer Gasversorgung Gas zugeführt werden, so dass sich aus dem daraus entstehenden Gleichgewicht ein Druck in der Kammer einstellt.

Mittels der Vakuumkammer 802 kann im Betrieb der Verdampfungsanordnung 100 ein Vakuumdruck (vereinfacht auch als Vakuum bezeichnet) bereitgestellt werden, welchem der Verdampfungstiegel 102 und/oder das darin angeordnete Verdampfungsgut ausgesetzt ist. Gemäß verschiedenen Ausführungsformen kann ein Kammergehäuse, z.B. eine darin bereitgestellte Vakuumkammer, derart eingerichtet sein, dass darin ein Unterdruck (d.h. ein Druck von kleiner als Atmosphärendruck) bereitgestellt werden kann, z.B. ein Vakuumdruck (d.h. ein Druck von weniger als 0,3 bar), z.B. ein Druck in einem Bereich von ungefähr 10 mbar bis ungefähr 1 mbar (mit anderen Worten Grobvakuumdruck) oder weniger, z.B. ein Druck in einem Bereich von ungefähr 1 mbar bis ungefähr 10⁻³ mbar (mit anderen Worten Feinvakuumdruck) oder weniger, z.B. ein Druck in einem Bereich von ungefähr 10⁻³ mbar bis ungefähr 10⁻⁷ mbar (mit anderen Worten Hochvakuumdruck) Der Atmosphärendruck (z.B. ungefähr 1 bar) kann derjenige Druck sein, der von außen auf das Kammergehäuse wirkt.

Die Fluidleitung 104 kann das Tiegelinnere des Vorratstiegels 112 und das Tiegelinnere des Verdampfungstiegels 102 miteinander fluidleitend verbinden, so dass ein Fluid (z.B. die Schmelze) zwischen diesen ausgetauscht werden kann. Die hochtemperaturfeste Fluidleitung 104 kann beispielsweise in eine Seite (z.B. den Boden) des jeweiligen Tiegels einkoppeln, welche der Dampfaustrittsöffnung gegenüberliegt. Die Fluidleitung 104 kann beispielsweise bodenseitig mit der Tiegelwanne gekuppelt sein.

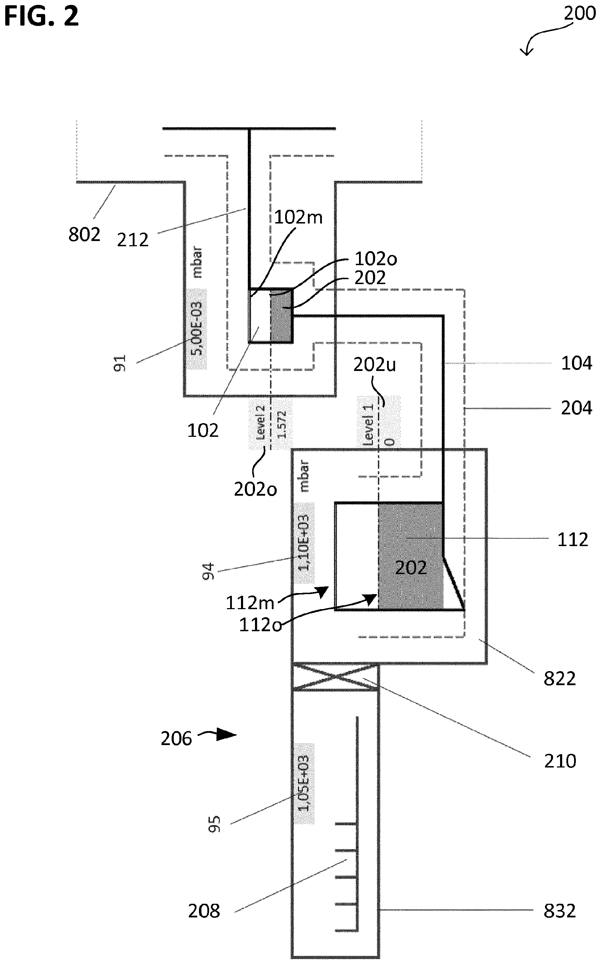

**Fig.2** veranschaulicht eine Verdampfungsanordnung 200 gemäß verschiedenen Ausführungsformen in einer schematischen Seitenansicht oder Querschnittsansicht, z.B. eingerichtet wie die Verdampfungsanordnung 100, wobei die Verdampfungsanordnung 200 ferner vom Typ der Drucknachfüllung ist.

Der Vorratstiegel 112 und der Verdampfungstiegel 102 der Verdampfungsanordnung 200 können höhenversetzt zueinander angeordnet sein. Dies ermöglicht es, kleinere Tiegel zu verwenden. Beispielsweise kann der Verdampfungstiegel 102 eine Dampfaustrittsöffnung 102m aufweisen, welche bezüglich eines Nullniveaus eine größere Höhe aufweist als die Materialzuführöffnung 112m des Vorratstiegels 112 (d.h. dieser wird als Zuführtiegel verwendet). Dasselbe kann für deren Unterseiten (z.B. Böden) gelten.

Unter dem Nullniveau versteht man eine Fläche, der die Höhe null zugewiesen wird, z.B. gemäß dem sogenannten "European Vertical Reference System" (EVRS). Im Folgenden wird das einfacher verständliche anlagenspezifische Nullniveau verwendet, welches der Höhe des niedrigsten Badspiegels der Schmelze entspricht (auch als Level 1 bezeichnet). Das Beschriebene kann aber auch für ein anderes Nullniveau gelten, z.B. das geodätische Nullniveau (z.B. Meeresspiegelhöhe, Normalhöhennull oder Wiener Null).

Die Höhenversetzung ermöglicht es ferner, den hydrostatischen Druck (z.B. das Gewicht der Flüssigkeitssäule) der Schmelze zum Antreiben einer Fließbewegung (auch als fließende Verlagerung bezeichnet) der Schmelze zu verwenden, z.B. durch die Fluidleitung hindurch und/oder um den Verdampfungstiegel 102 in den Vorratstiegel 112 hinein zu entleeren. Dazu kann eine Unterseite des Verdampfungstiegels 102 beispielsweise eine größere Höhe aufweisen als die Oberseite des Vorratstiegels 112.

Beispielsweise kann im Betrieb der Verdampfungsanordnung 200 ein Badspiegel 102o (auch als Flüssigkeitsstand oder Flüssigkeitsspiegel bezeichnet) der Schmelze 202 in dem Verdampfungstiegel 102 eine Höhe 202o (auch als Level 2 bezeichnet) aufweisen die größer ist als eine Höhe 202u (auch als Level 1 bezeichnet) des Badspiegels 112o der Schmelze 202 in dem Vorratstiegel 112 (auch als Vorratsspiegel 112o bezeichnet). Die Höhe eines Badspiegels (d.h. Höhe des Flüssigkeitsspiegels) wird auch als Spiegelhöhe bezeichnet.

Die Verdampfungsanordnung 200 kann eine Heizvorrichtung 204 aufweisen, welche eingerichtet ist, dem Vorratstiegel 112, der Fluidleitung 104 und/oder dem Verdampfungstiegel 102 thermische Energie zuzuführen (auch als Erwärmen oder Beheizen bezeichnet). Die Heizvorrichtung 204 kann eingerichtet sein, elektrische Energie in die thermische Energie umzuwandeln. Dazu kann die Heizvorrichtung 204 beispielsweise eine Heizwendel aufweisen und optional eine thermisch isolierende Hülle, welche die Heizwendel umgibt. Beispielsweise kann die Heizwendel den Vorratstiegel 112, die Fluidleitung 104 und/oder den Verdampfungstiegel 102 umgeben (z.B. umhüllen).

Ferner kann die Verdampfungsanordnung 200 eine Materialnachfüllungsvorrichtung 206 aufweisen, welche eingerichtet ist, dem Vorratstiegel 112 ein festes Verdampfungsgut zuzuführen (z.B. unter Überdruck und/oder Unterdruck). Die Materialnachfüllungsvorrichtung 206 der Verdampfungsanordnung 200 kann vom Typ der Drucknachfüllung sein, d.h. dass diese das Verdampfungsgut auch unter Überdruck und/oder Unterdruck zuführen kann.

In dem Fall kann die Verdampfungsanordnung 200 eine erste Druckkammer 822 (auch als Tiegelkammer bezeichnet) aufweisen, in welcher der Vorratstiegel 112 angeordnet ist. Die Materialnachfüllungsvorrichtung 206 kann in Analogie eine zweite Druckkammer 832 aufweisen, in welcher ein Materialförderer 208 (d.h. eine Einrichtung zur Beförderung des Verdampfungsguts) angeordnet ist.

Die Tiegelkammer 822 und die zweite Druckkammer 832 können mittels einer Ventils 210 (auch als Chargierventil bezeichnet) miteinander gekoppelt sein. Das Chargierventil 210 kann derart eingerichtet sein, dass dieses in einem geöffneten Zustand die zwei Druckkammern 832, 822 gasleitend miteinander verbindet und in einem geschlossenen Zustand diese vakuumdicht voneinander separiert (z.B. hermetisch voneinander separiert). Das Chargierventil 210 kann ferner derart eingerichtet sein, dass eine physische Verbindung zwischen den zwei Druckkammern 832, 822 durch das Ventil hindurch derart groß ist, dass der Materialförderer 208 (auch als Chargiervorrichtung bezeichnet) aus der zweiten Druckkammer 832 in die Tiegelkammer 822 verlagert werden kann und andersherum. Die zweite Druckkammer 832 kann den Deckel aufweisen, durch welchen der Materialförderer 208 mit dem Verdampfungsgut beladen werden kann.

Im Betrieb der Verdampfungsanordnung 200 kann ein erster Gasdruck 91 (in der Vakuumkammer 802), welcher auf den Verdampfungstiegel 102 bzw. die darin angeordnete Schmelze wirkt, ein Vakuumdruck sein (z.B. ein Druck des Feinvakuums). Im Betrieb der Verdampfungsanordnung 200 kann ein zweiter Gasdruck 94 (in der Tiegelkammer 822), welcher auf den Vorratstiegel 112 bzw. die darin angeordnete Schmelze wirkt, ein Überdruck sein. Je nach Betriebsphase der Verdampfungsanordnung 200 kann ein dritter Gasdruck 95 in der zweiten Druckkammer 832 der zweite Druck oder Atmosphärendruck sein, wie später noch genauer beschrieben wird.

Ferner kann die Verdampfungsanordnung 200 eine Dampfführung 212 (auch als Dampfführungsvorrichtung bezeichnet) aufweisen, welche mit dem Verdampfungstiegel 102 gekoppelt ist und den Dampf zu einem Beschichtungsbereich hin führt, z.B. mittels eines Dampfströmungskanals und/oder entlang eines (z.B. gekrümmten und/oder abgewinkelten) Pfads.

Der Typ der Drucknachfüllung ermöglicht es, den Badspiegel 102o in dem Verdampfungstiegel 102 (auch als Verdampfungsspiegel 102o bezeichnet) zu beeinflussen, indem der zweite Gasdruck verändert wird. Anschaulich wird die Druckdifferenz zwischen dem ersten Gasdruck 91 (auch als Kammerdruck 91 oder p₁ bezeichnet) und dem zweiten Gasdruck (auch als Ausgleichsdruck 94 oder p₂ bezeichnet) verändert, was zur Folge hat, dass die Schmelze in den Verdampfungstiegel 102 hinein oder aus diesem heraus fließt, um die Veränderung der Druckdifferenz zu kompensieren. Die im Folgenden beschriebene Druckdifferenz kann sich auf die Differenz zwischen dem Kammerdruck 91 und dem Ausgleichsdruck 94 beziehen.

Die Druckdifferenz Δp = p₁-p₂ kann dem Schweredruck pₕ der Schmelze entsprechen, wobei pₕ = ρ·g·h ist, wobei ρ die Dichte der Schmelze ist, g die Erdbeschleunigung ist und h die Höhendifferenz zwischen Level 1 und Level 2 ist. Die Druckdifferenz kann beispielsweise von einer Steuervorrichtung ermittelt und in ein Ansteuern eines oder mehr als eines Stellglieds umgesetzt werden.

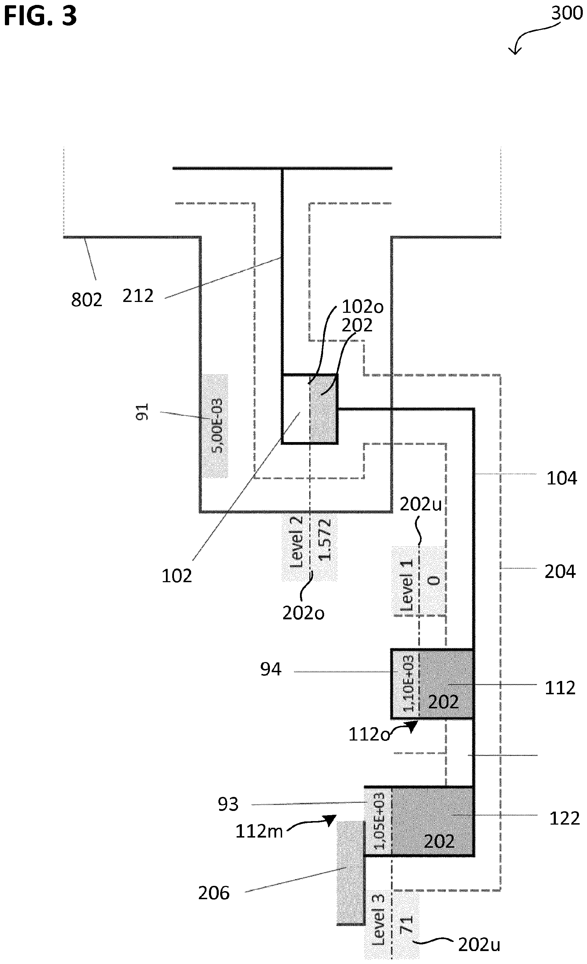

**Fig.3** veranschaulicht eine Verdampfungsanordnung 300 gemäß verschiedenen Ausführungsformen in einer schematischen Seitenansicht oder Querschnittsansicht, z.B. analog eingerichtet wie die Verdampfungsanordnung 200, mit dem Unterschied, dass die Verdampfungsanordnung 300 vom Typ der Atmosphärennachfüllung ist. Dann können der Materialförderer 206 und/oder der Vorratstiegel 112 an Atmosphäre (z.B. freistehend) angeordnet sein. Mit anderen Worten können die Tiegelkammer 822 und/oder die zweite Druckkammer 832 weggelassen sein.

Um den Überdruck 94 bereitzustellen, kann der Vorratstiegel 112 der Verdampfungsanordnung 300 (dann auch als Ausgleichstiegel 112 bezeichnet) als Ausgleichsbehälter eingerichtet sein, z.B. druckstabil.

Ferner kann die Verdampfungsanordnung 300 einen zusätzlichen Vorratstiegel 122, der als Zuführtiegel 122 verwendet wird, aufweisen.

Der Zuführtiegel 122 kann beispielsweise deckenseitig (d.h. an der Oberseite) offen sein, d.h. die Materialzuführöffnung 112m aufweisen. Der Zuführtiegel 122 kann beispielsweise permanent an Atmosphäre (z.B. freistehend) angeordnet sein, d.h. in diesem kann ein atmosphärischer Druck 93 herrschen. Der Zuführtiegel 122 kann mit der Fluidleitung 104 fluidleitend gekoppelt sein.

Beispielsweise kann das Tiegelinnere des Zuführtiegels 122 weniger von der atmosphärischen Umgebung gassepariert sein als das Tiegelinnere des Ausgleichstiegels 112. Beispielsweise kann der Tiegeldeckel des Ausgleichstiegels 112 diesen auf seiner Oberseite deckenseitig gasdicht verschließen. Der Tiegeldeckel kann auch weggelassen werden, wenn die Oberseite des Ausgleichstiegels 112 beispielsweise monolithisch verschlossen ist. Allgemeiner gesprochen kann der Ausgleichstiegel 112 eine Druckkammer (dann auch als Druckbehälter oder Druckkörper bezeichnet) aufweisen, welche das Tiegelinnere bereitstellt. Unter einem Druckkörper (Druckbehälter) kann ein Hohlkörper verstanden werden, bei dem während des Betriebs eine Differenz zwischen Innen- und Außendruck besteht.

Der Ausgleichstiegel 112 kann erreichen, dass zwischen dem Verdampfungsgut 202 in dem Ausgleichstiegel 112 und der Tiegeloberseite ein Gaspolster 94 eingeschlossen ist, dessen Druckdifferenz zu dem ersten Druck 91 analog zu der Verdampfungsanordnung 200 zum Verändern des Verdampfungsspiegels 102o verwendet werden kann. Im Betrieb kann die Spiegelhöhe 202u in dem Ausgleichstiegel 112 kleiner sein als die Spiegelhöhe in dem Zuführtiegel 122 und/oder dem Verdampfungstiegel 102.

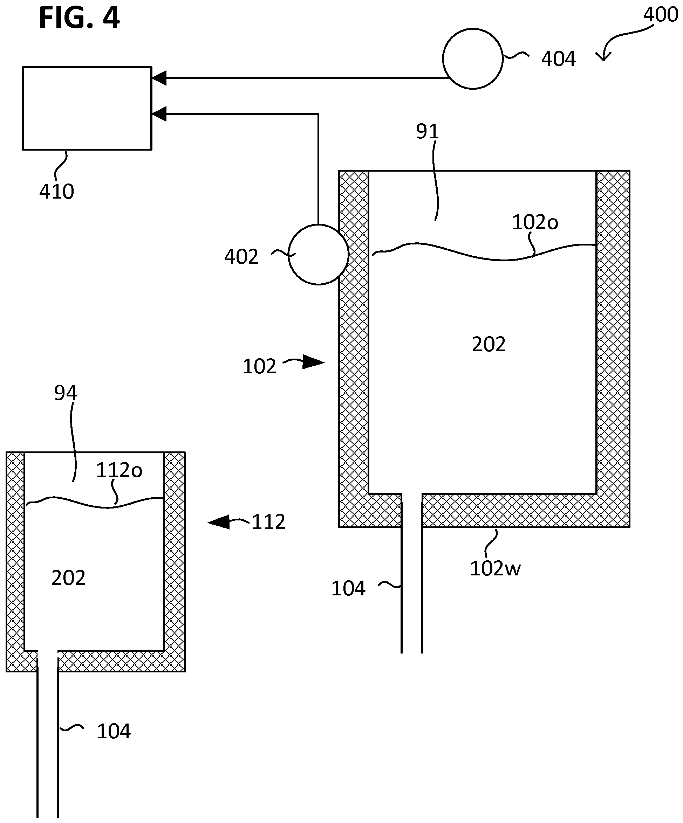

**Fig.4** veranschaulicht eine Verdampfungsanordnung 400 gemäß verschiedenen Ausführungsformen in einer schematischen Detailansicht, z.B. analog eingerichtet wie eine der Verdampfungsanordnungen 100 oder 300, wobei die Verdampfungsanordnung 400 ferner eine Sensorvorrichtung aufweist. Die Sensorvorrichtung kann einen oder mehr als einen Sensor aufweisen, z.B. einen Temperatursensor 402 und/oder einen Füllstandsensor 404. Der Temperatursensor 402 kann eingerichtet sein, eine Temperatur (auch als Verdampfungstemperatur bezeichnet) des Verdampfungsguts 202 in dem Verdampfungstiegel 102 und/oder der Tiegelwanne 102w zu erfassen.

Der Füllstandsensor 404 kann eingerichtet sein, einen Füllstand eines Tiegels (z.B. des Verdampfungstiegels 102 und/oder des Vorratstiegels), d.h. eine Angabe über die Menge des Verdampfungsguts 202 in dem Tiegel, zu erfassen. Beispielsweise kann der Füllstandsensor 404 optisch die Position des entsprechenden Badspiegels in dem Tiegel erfassen. Alternativ oder zusätzlich kann der Füllstandsensor 404 ein Gewicht des Tiegels 102 mit dem Verdampfungsgut 202 darin erfassen. Der Füllstand des Tiegels kann zu der Spiegelhöhe 202o im Verdampfungstiegel 102 korrelieren, z.B. mit dieser zunehmen bzw. abnehmen. Der Füllstand des Tiegels kann beispielsweise als Masse oder als Spiegelhöhe angegeben werden.

Die Verdampfungsanordnung 400 kann ferner eine Steuervorrichtung 410 aufweisen, welche eingerichtet ist, die Komponenten der Verdampfungsanordnung 400 anzusteuern, z.B. gemäß einer jeweiligen Betriebssequenz, wie später noch genauer beschrieben wird. Das Ansteuern kann beispielsweise auf Grundlage der Messdaten der Sensorvorrichtung erfolgen.

In einer Verdampfungssequenz kann die Steuervorrichtung 410 beispielsweise eingerichtet sein, die Verdampfungsrate zu steuern (z.B. zu regeln) mittels Stellens der Verdampfungstemperatur und/oder des Füllstands (d.h. diese werden von einer Stellgröße beeinflusst). Das der Verdampfungstemperatur zugehörige Stellglied kann beispielsweise die Heizvorrichtung 204 sein. Das dem Füllstand zugehörige Stellglied kann beispielsweise eine Gasverlagerungsvorrichtung (z.B. eine Gasversorgung und/oder eine Pumpe aufweisend) sein, welche das Inertgas mit dem Ausgleichsdruck 94 bereitstellt.

In einer Verdampfungssequenz kann in dem Vorratstiegel 112 beispielsweise ein inerter Überdruck 94 herrschen (z.B. mindestens ungefähr 100 mbar über Normaldruck), derart, dass der höchste zu erwartende Atmosphärendruck (wetterabhängig) sicher überschritten wird.

Der Typ der Drucknachfüllung ermöglicht eine konstante (wetterunabhängige) Flüssigkeitssäule für das verdampfende Verdampfungsgut und somit gleichbleibende Prozessbedingungen, z.B. unabhängig vom Wetter und/oder dem Standort. Bei Zink als Verdampfungsgut kann beispielsweise die Spiegelhöhe 202o (auch als Level 2 bezeichnet) im Verdampfungstiegel 102o ungefähr 1572 mm (Millimeter) über dem Nullniveau sein. Das Nullniveau kann auf der niedrigsten Spiegelhöhe 202u sein, z.B. der Spiegelhöhe in dem Vorratstiegel 112 (auch als Level 1 bezeichnet). Der Vorratsspiegel 112o kann beispielsweise der niedrigste Badspiegel der Schmelze sein.

Der Typ der der Atmosphärennachfüllung kann das Befüllen mit Verdampfungsgut erleichtern und die Konstruktion vereinfachen. Allerdings kann eine variable (wetterabhängige) Flüssigkeitssäule für das nachgeführte Verdampfungsgut (auch als Verdampfungsmaterial bezeichnet) bereitgestellt werden. Bei Zink als Verdampfungsgut kann beispielsweise die Spiegelhöhe (dann auch als Level 3 bezeichnet) im Zuführtiegel 122 ungefähr 71mm (z.B. bei 1050 mbar Atmosphärendruck) über dem Nullniveau sein. Im Allgemeinen kann das Level 3 zwischen dem Level 1 und dem Level 2 sein und/oder zumindest größer als das Level 1.

Der als Zuführtiegel verwendete Tiegel kann (beispielsweise kontinuierlich oder zyklisch) mit Verdampfungsgut beschickt (d.h., diese wird dem Zuführtiegel zugeführt) werden, ohne Level 1 signifikant zu verändern. Einer Änderung des Level 1 kann mittels Regelns der Druckdifferenz (auch als Füllstand-Regelmechanismus bezeichnet) entgegengewirkt werden, wie nachfolgend noch genauer beschrieben wird. Anschaulich kann die Druckdifferenz den Schweredruck der Flüssigkeitssäule (z.B. den Höhenunterschied zwischen Level 2 und Level 1) ausgleichen.

Beim Belüften der Bedampfungskammer 802 (d.h. wenn der Kammerdruck 91 vergrößert wird) kann der Verdampfungsspiegel 102o aufgrund der Flüssigkeitssäule auf Level 1 sinken, welches beispielsweise gegenüber einem geodätischen Nullniveau leicht ansteigt aufgrund des aus dem Verdampfungstiegel 102 abgeflossenen Verdampfungsguts. Nachfolgend kann die Schmelze aus dem als Zuführtiegel verwendete Tiegel im Wesentlichen vollständig in einen Warmhaltebehälter gepumpt werden (z.B. mittels einer Metallschmelzen-Pumpe).

Im Fall des Typs der Atmosphärennachfüllung wird dabei auch der Ausgleichstiegel 112 geleert. Dazu kann dessen Boden (der Tiegelwanne) auf derselben Höhe oder höher sein als der Boden des Zuführtiegels 122.

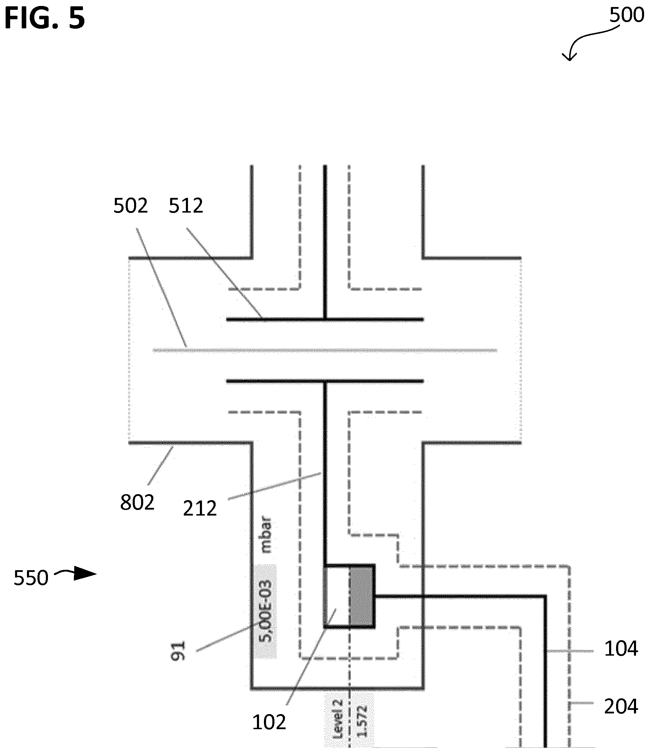

**Fig.5** veranschaulicht eine Prozessieranordnung 500 gemäß verschiedenen Ausführungsformen in einer schematischen Seitenansicht oder Querschnittsansicht, wobei Prozessieranordnung 500 eine Verdampfungsanordnung aufweist, die beispielsweise eingerichtet sein kann, wie eine der Verdampfungsanordnungen 100 bis 400.

Die Prozessieranordnung 500 kann eine Transportvorrichtung 502 aufweisen, welche eingerichtet ist, ein Substrat durch einen Beschichtungsbereich 512 hindurch zu transportieren. Der Beschichtungsbereich 512 kann in der oder einer anderen Vakuumkammer 802 angeordnet sein. Die Dampfführung 212 kann den Verdampfungstiegel 102 (z.B. dessen Tiegelinneres) mit dem Beschichtungsbereich 512 fluidleitend koppeln.

Die Transportvorrichtung 502 kann beispielsweise eine Vielzahl von Transportrollen (nicht dargestellt) aufweisen, welche eingerichtet sind ein plattenförmiges Substrat oder eine bandförmiges Substrat (z.B. eine Folie) zu transportieren.

Im Folgenden werden verschiedene Betriebssequenzen anhand der Verdampfungsanordnung 550 beschrieben, welche in Analogie für eine der Verdampfungsanordnungen 100 bis 400 gelten können.

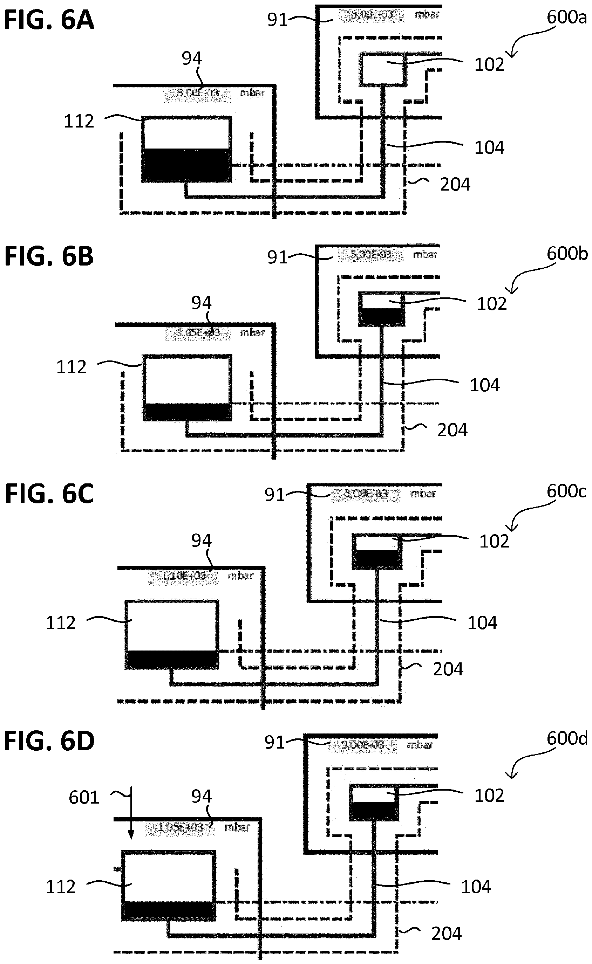

**Fig.6A bis Fig.6D** veranschaulichen jeweils den Betrieb der Verdampfungsanordnung 550 gemäß verschiedenen Ausführungsformen in einer schematischen Seitenansicht oder Querschnittsansicht, wobei der gemäß einer Inbetriebnahmesequenz als Betriebssequenz und einer nachfolgenden Verdampfungssequenz als Betriebssequenz erfolgt.

Die Inbetriebnahmesequenz kann eine erste Phase 600a (auch als erste Inbetriebnahmephase bezeichnet) aufweisen, in welcher der Verdampfungstiegel 102, die Fluidleitung 104 und der Vorratstiegel 112 jeweils eine Temperatur unterhalb der Schmelztemperatur des Verdampfungsguts (vereinfacht auch als kalt bezeichnet) aufweisen. Der Verdampfungstiegel 102 kann ungefüllt sein (vereinfacht auch als leer bezeichnet) und der Vorratstiegel 112 kann gefüllt sein.

In der ersten Inbetriebnahmephase 600a können die Vakuumkammer 802 und/oder der Vorratstiegel 112 evakuiert sein oder werden (d.h. abgepumpt), so dass der Kammerdruck 91 bzw. Ausgleichsdruck 94 abnimmt.

Am Ende der ersten Inbetriebnahmephase 600a können der Kammerdruck 91 und/oder der Ausgleichsdruck 94 beispielsweise in einem Vakuumdruckbereich sein, z.B. in einem Feinvakuumdruckbereich. Alternativ oder zusätzlich kann am Ende der ersten Inbetriebnahmephase 600a die Druckdifferenz zwischen dem Ausgleichsdruck 94 und dem Kammerdruck 91 ein Minimum im Betrieb der Verdampfungsanordnung 550 annehmen und/oder weniger als 1 mbar sein.

Die Inbetriebnahmesequenz kann eine zweite Phase 600b (auch als zweite Inbetriebnahmephase bezeichnet) aufweisen, in welcher der Verdampfungstiegel 102, die Fluidleitung 104 und der Vorratstiegel 112 jeweils auf eine Temperatur oberhalb der Schmelztemperatur des Verdampfungsguts (vereinfacht auch als heiß bezeichnet) gebracht sind oder werden. Dies führt zum Schmelzen des Verdampfungsguts bzw. hält die Schmelze flüssig. Das Schmelzen des Verdampfungsguts kann in dem jeweiligen als Zuführtiegel 112, 122 verwendeten Tiegel (und optional in dem Ausgleichstiegel 112) erfolgen. Der zum Schmelzen verwendete Zuführtiegel 112, 122 kann auch als Vorratstiegel bezeichnet werden.

Ein Gasdruck 94 in dem Vorratstiegel 112 (auch als Ausgleichsdruck 94 bezeichnet) bzw. die Druckdifferenz können vergrößert werden, so dass die Druckdifferenz die Schmelze des Verdampfungsguts durch die Fluidleitung 104 hindurch in den Verdampfungstiegel 102 presst. Dabei kann die Spiegelhöhe 202o in dem Verdampfungstiegel 102 zunehmen und die Spiegelhöhe 202u in dem Vorratstiegel 112 abnehmen.

Die Verdampfungssequenz kann eine erste Phase 600c (auch als erste Verdampfungsphase bezeichnet) aufweisen, in welcher der Verdampfungstiegel 102, die Fluidleitung 104 und der Vorratstiegel 112 die Schmelze aufgenommen haben. Ferner kann die Schmelze in dem Verdampfungstiegel 102 in den Dampf überführt werden. Dabei nimmt die Menge der Schmelze ab, was zur Folge hat, dass die Spiegelhöhe 202o im Verdampfungstiegel 102 sinkt. Diesem Absinken der Spiegelhöhe 202o im Verdampfungstiegel 102 in der ersten Verdampfungsphase 600c kann gemäß verschiedenen Ausführungsformen entgegengewirkt werden mittels Vergrößerns der Druckdifferenz (z.B. des Ausgleichsdrucks 94), z.B. gemäß einem Füllstand-Regelmechanismus wie später noch genauer beschrieben wird. Das Vergrößern der der Druckdifferenz (z.B. des Ausgleichsdrucks 94) bewirkt, dass die Schmelze aus dem Vorratstiegel 112 in den Verdampfungstiegel 102 fließt, so dass die Spiegelhöhe im Verdampfungstiegel 102 stabilisiert wird auf Kosten der Spiegelhöhe im Vorratstiegel 112 (welche sinkt).

Am Ende der ersten Verdampfungsphase 600c kann die Druckdifferenz zwischen dem Ausgleichsdruck 94 und dem Kammerdruck 91 ein Maximum im Betrieb der Verdampfungsanordnung 550 annehmen und/oder mindestens 1 bar sein. Alternativ oder zusätzlich kann am Ende der ersten Verdampfungsphase 600c die Höhendifferenz zwischen der Spiegelhöhe 202o im Vorratstiegel 102 und der Spiegelhöhe 202o im Verdampfungstiegel 102 ein Maximum der Inbetriebnahmesequenz annehmen.

Die Verdampfungssequenz kann eine zweite Phase 600c (auch als zweite Verdampfungsphase bezeichnet) aufweisen, in welcher dem Vorratstiegel 112 (z.B. festes und/oder flüssiges) Verdampfungsgut zugeführt 601 wird, z.B. mittels einer Materialzuführungsvorrichtung 206 (z.B. vom Typ der Drucknachfüllung oder Atmosphärennachfüllung). Dabei nimmt die Menge des Verdampfungsguts zu, was zur Folge hat, dass die Spiegelhöhe 202o im Verdampfungstiegel 102 zunimmt. Diesem Zunehmen der Spiegelhöhe 202o im Verdampfungstiegel 102 in der zweiten Verdampfungsphase 600d kann gemäß verschiedenen Ausführungsformen entgegengewirkt werden mittels Verkleinerns des Ausgleichsdrucks, z.B. gemäß einem Füllstand-Regelmechanismus wie später noch genauer beschrieben wird. Das Verkleinern des Ausgleichsdrucks bewirkt, dass die Schmelze in dem Vorratstiegel 112 verbleibt, so dass die Spiegelhöhe 202o im Verdampfungstiegel 102 stabilisiert wird auf Kosten der Spiegelhöhe 202o im Vorratstiegel 102 (welche steigt).

Das zugeführte feste Verdampfungsgut kann in dem Vorratstiegel 112 geschmolzen werden (auch als Schmelzen von Verdampfungsgut bezeichnet).

Die Verdampfungssequenz kann periodisch wiederholt werden, bis eine Außerbetriebnahmesequenz initiiert wird.

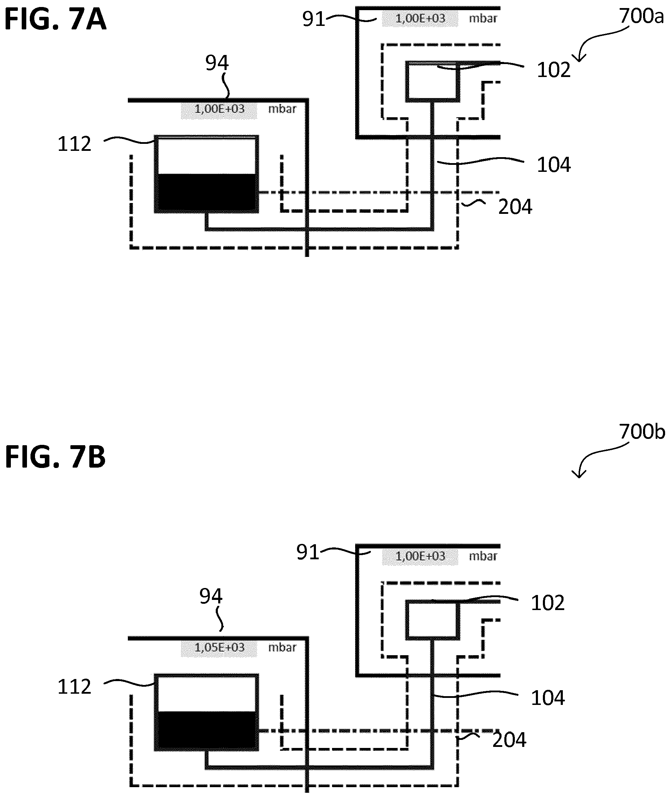

**Fig.7A und Fig.7B** veranschaulichen jeweils den Betrieb Verdampfungsanordnung 550 gemäß verschiedenen Ausführungsformen in einer schematischen Seitenansicht oder Querschnittsansicht, wobei der Betrieb gemäß einer Außerbetriebnahmesequenz 700a als Betriebssequenz oder alternativ gemäß einer zusätzlichen Außerbetriebnahmesequenz 700b als Betriebssequenz (auch als Notabschaltungssequenz bezeichnet) erfolgt.

Die Außerbetriebnahmesequenz 700a kann eine erste Phase aufweisen, in welcher der Ausgleichsdruck 94 verringert (z.B. auf den Kammerdruck 91 oder weniger) wird. Dies erreicht, dass die Schmelze aus dem Verdampfungstiegel 102 in den Vorratstiegel 112 fließt. Ist der Verdampfungstiegel 102 leer, kann dieser abgekühlt werden, z.B. bis dieser kalt ist (z.B. bis auf 100°C oder weniger, z.B. auf Raumtemperatur). Danach können der Kammerdruck und der Ausgleichsdruck 94 auf Atmosphärendruck gebracht werden (z.B. mittels Belüftens der Vakuumkammer 802 und/oder des Vorratstiegels 112). Dabei kann der steigende Kammerdruck im Wesentlichen dem steigenden Ausgleichsdruck entsprechen, so dass die Schmelze in dem Vorratstiegel 112 verbleibt.

Die Außerbetriebnahmesequenz kann eine zweite Phase aufweisen, in welcher der Vorratstiegel 112 belüftet ist und nachfolgend die Schmelze (z.B. flüssiges Material) aus dem Vorratstiegel 112 herausgepumpt werden kann.

Alternativ kann die Außerbetriebnahmesequenz aufweisen, den Vorratstiegel 112 (z.B. gemeinsam mit dem Verdampfungstiegel 102) abzukühlen mit dem Verdampfungsgut darin, z.B. bis dieser kalt ist (z.B. bis auf 100°C oder weniger, z.B. auf Raumtemperatur). Dabei erstarrt die Schmelze in dem Vorratstiegel 112 und in der Fluidleitung 104.

Das Abkühlen des Vorratstiegels 112 und/oder des Vorratstiegels 112 kann aufweisen, die Heizvorrichtung zu deaktivieren.

Die Außerbetriebnahmesequenz kann beispielsweise initiiert werden (z.B. von der Steuervorrichtung 410 oder auch manuell), wenn ein Beschichtungsvorgang beendet ist oder wenn die Verdampfungsvorrichtung 550 gewartet werden soll.

Die Notabschaltungssequenz (anschaulich ein unplanmäßiges Belüften der Vakuumkammer 802 im heißem Zustand des Verdampfungstiegels) kann aufweisen, dass die Vakuumkammer 802 belüftet wird, wenn der Verdampfungstiegel 102 noch heiß ist. Ferner kann die Heizvorrichtung deaktiviert werden. Das Belüften der Vakuumkammer 802 hat zur Folge, dass die Schmelze aus dem Verdampfungstiegel 102 in den Vorratstiegel 112 fließt. Der Ausgleichsdruck 94 kann, z.B. wenn der Verdampfungstiegel 102 im Wesentlichen leer ist, dem Kammerdruck 91 angepasst werden, wodurch der Rest der Schmelze in den Vorratstiegel 112 fließt.

Nachfolgend kann die Schmelze 220 (z.B. flüssiges Material) aus dem Vorratstiegel 112 herausgepumpt werden oder dieser kann (z.B. gemeinsam mit dem Verdampfungstiegel 102) abgekühlt werden mit dem Verdampfungsgut darin, z.B. bis dieser kalt ist (z.B. bis auf 100°C oder weniger, z.B. auf Raumtemperatur).

Die Notabschaltungssequenz kann beispielsweise initiiert werden (z.B. von der Steuervorrichtung 410 oder auch manuell), wenn ein Fehler der Verdampfungsvorrichtung 550 ermittelt wird.

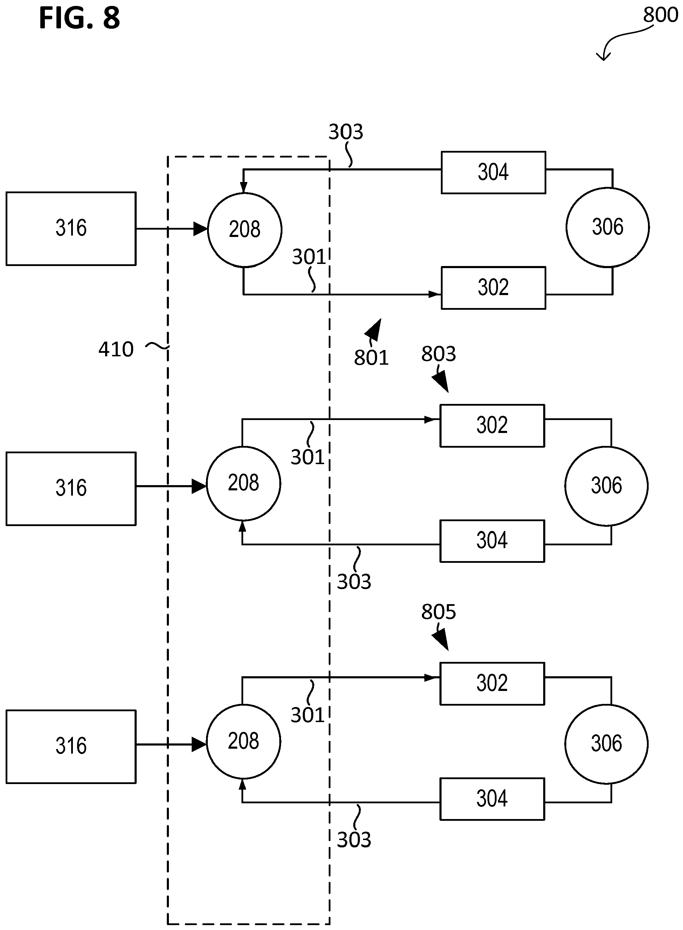

**Fig.8** veranschaulicht den Füllstand-Regelmechanismus 800 gemäß verschiedenen Ausführungsformen in einem Regeldiagramm. Die zu steuernde bzw. zu regelnde Größe 306 (vereinfacht auch als Regelgröße bezeichnet) der Verdampfungsvorrichtung 550 kann im Allgemeinen eine Verdampfungsrate repräsentieren. Die Verdampfungsrate ist ein Maß für die Menge (z.B. Masse) an Verdampfungsgut, die pro Zeiteinheit verdampft wird und kann beispielsweise auch als Normvolumenstrom (des von dem Verdampfungstiegel 102 emittierten Dampfes) angegeben werden.

Die Regelgröße kann beispielsweise die Verdampfungstemperatur sein und/oder der Füllstand des Verdampfungstiegels. Je größer der Füllstand ist, desto größer kann die Verdampfungsrate sein. Je größer die Verdampfungstemperatur ist, desto größer kann die Verdampfungsrate sein. Es kann allerdings auch jede andere Regelgröße verwendet werden, welche die Verdampfungsrate repräsentiert, z.B. die Verdampfungsrate selbst.

Gemäß verschiedenen Ausführungsformen kann als Größe eine physikalische Größe verstanden werden, welche eine quantitativ erfassbare Eigenschaft einer physikalischen Entität (z.B. eines Objektes, eines Vorgangs oder eines Zustand) repräsentiert (z.B. diese beschreibt und/oder zu dieser korreliert). Ihr Zustand kann optional von der Zeit t und/oder dem Ort abhängen.

Der Ist-Zustand der Regelgröße 306 kann den Ist-Zustand der Verdampfungsrate repräsentieren und kann von einem Messglied 304 erfasst werden. Das Messglied 304 kann den erfassten Ist-Zustand der Regelgröße 306 als erste Eingangsgröße 303 (auch als Rückführungsgröße 303 bezeichnet) der Steuervorrichtung 410 zuführen (auch als Rückführung bezeichnet). Allgemeiner gesprochen kann die Rückführungsgröße 303 auch ein Vektor sein, je nach der Anzahl der zugeführten Messdaten. Ferner kann der Steuervorrichtung 410 ein Soll-Zustand 316 der Regelgröße 306 als zweite Eingangsgröße 316 (auch als Vorgabegröße bezeichnet) zugeführt werden, z.B. eine Soll-Verdampfungsrate.

Die Steuervorrichtung 410 kann die Rückführungsgröße 303 mit der Vorgabegröße 316 vergleichen und auf Grundlage eines Ergebnisses des Vergleichens ein Stellglied 302 ansteuern 301. Das Stellglied 302 kann derart angesteuert werden, dass eine Abweichung des Soll-Zustands von dem Ist-Zustand der Regelgröße 306 (auch als Regelabweichung bezeichnet) minimiert wird.

Als Stellgröße wird die diejenige Größe bezeichnet, welche verändert wird, um ein Einfluss auf die Regelgröße zu nehmen. Der momentane Wert der Stellgröße ist der Stellwert. Je nach Aufbau und Konfiguration können verschiedene Arten von Stellgliedern und Stellgrößen verwendet werden, um auf dieselbe Regegröße Einfluss zu nehmen. Beispielsweise kann der Druck eines Gases (auch als Gasdruck bezeichnet) beeinflusst werden, indem der Normvolumenstrom an Gas, das zugeführt und/oder entzogen wird, verändert oder indem eine Temperatur des Gases verändert wird. Der Normvolumenstrom kann wiederum verändert werden, indem ein Ventil zumindest teilweise (d.h. teilweise oder vollständig) geöffnet bzw. geschlossen wird. Ebenso kann das Gas komprimiert und/oder entspannt werden, um dessen Druck zu ändern. Bezüglich eines Ventils kann die Stellgröße beispielsweise die Stellung des Stellantriebs oder eine diesem zugeführte Spannung und/oder Frequenz sein. Ein weiteres Beispiel für die Stellgröße ist der Öffnungszustand eines Ventils. Bei einem pneumatischen Stellantrieb wird beispielsweise der pneumatische Druck auf den Stellantrieb als Stellgröße verwendet.

Beispielsweise kann die Steuervorrichtung 410 einen oder mehr als einen Regelkreis 801, 803, 805 implementieren, von denen jeder Regelkreise eingerichtet ist, genau eine Regelgröße 306 zu regeln. Ein erster Regelkreis 801 kann beispielsweise die Verdampfungstemperatur als Regelgröße 306 verwenden. Ein zweiter Regelkreis 803 kann beispielsweise den Füllstand des Verdampfungstiegels 102 als Regelgröße 306 verwenden. Ein dritter Regelkreis 805 kann beispielsweise den Vorrat geschmolzenen Verdampfungsguts als Regelgröße 306 verwenden.

Bei der Verdampfungstemperatur als Regelgröße 306 kann das Stellglied 302 beispielsweise die Heizvorrichtung 204 oder zumindest Teil dieser sein, z.B. deren Energieversorgung und/oder ein Schalter, der die Anzahl energieversorgter Heizwendeln schaltet. Die dazu korrespondierende Stellgröße kann beispielsweise die von der Heizvorrichtung 204 aufgenommene elektrische Leistung und/oder die dem Verdampfungstiegel 102 zugeführte thermische Leistung sein.

Bei dem Füllstand des Verdampfungstiegels 102 als Regelgröße 306 kann das Stellglied 302 beispielsweise die Gasverlagerungsvorrichtung oder zumindest Teil dieser sein, z.B. ein Ventil, mittels dessen dem Tiegelinneren ein Gas (z.B. ein Inertgas, wie beispielsweise Stickstoff oder Argon) zuführt und/oder entzogen wird. Bei dem Füllstand als Regelgröße kann das Stellglied 302 auch eine Pumpe sein, welche das Gas zuführt und/oder entzieht. Die dazu korrespondierende Stellgröße kann beispielsweise der Stellantrieb des Ventils oder ein Arbeitspunkt der Pumpe sein.

Das Ventil kann beispielsweise Teil der Gasversorgung und/oder der Pumpenanordnung sein, welches einen Normvolumenstrom, der das Inertgas aufweist, führt.

Bei dem Vorrat geschmolzenen Verdampfungsguts als Regelgröße 306 kann das Stellglied 302 beispielsweise die Materialnachfüllungsvorrichtung 206 oder ein Teil dieser sein, z.B. ein Antrieb der Materialnachfüllungsvorrichtung 206, mittels dessen dem Tiegelinneren des Vorratstiegels 112 das feste Verdampfungsgut zuführt wird. Die dazu korrespondierende Stellgröße kann beispielsweise der Stellantrieb des Antriebs oder ein Arbeitspunkt der Materialnachfüllungsvorrichtung 206 sein.

Im Folgenden werden verschiedene Beispiele beschrieben, die sich auf vorangehend Beschriebene und in den Figuren Dargestellte beziehen.

Beispiel 1 ist eine Verdampfungsanordnung, aufweisend: einen Verdampfungstiegel; einen oder mehr als einen Vorratstiegel, welcher mit dem Verdampfungstiegel fluidleitend gekoppelt ist zum Austauschen eines zu verdampfenden Verdampfungsguts zwischen dem Vorratstiegel und dem Verdampfungstiegel; eine Vakuumkammer, in welcher der Verdampfungstiegel angeordnet ist, wobei der Vorratstiegel außerhalb der Vakuumkammer angeordnet ist.

Beispiel 2 ist die Verdampfungsanordnung gemäß Beispiel 1, wobei der Verdampfungstiegel und der oder jeder Vorratstiegel höhenversetzt zueinander angeordnet sind, wobei beispielsweise eine Dampfaustrittsöffnung und/oder Bodenwand des Verdampfungstiegels bezüglich eines geodätischen Nullniveaus eine größere Höhe aufweist als eine Materialzuführöffnung und/oder Bodenwand des oder jedes Vorratstiegels.

Beispiel 3 ist die Verdampfungsanordnung gemäß Beispiel 1 oder 2, ferner aufweisend: eine Heizvorrichtung, welche eingerichtet ist, dem oder jedem Vorratstiegel und/oder dem Verdampfungstiegel thermische Energie zuzuführen.

Beispiel 4 ist die Verdampfungsanordnung gemäß einem der Beispiele 1 bis 3, ferner aufweisend: eine Fluidleitung, mittels welcher der oder jeder Vorratstiegel (z.B. bodenseitig) und der Verdampfungstiegel (z.B. bodenseitig) fluidleitend gekoppelt sind, wobei die Heizvorrichtung beispielsweise eingerichtet ist, der Fluidleitung thermische Energie zuzuführen.

Beispiel 5 ist die Verdampfungsanordnung gemäß Beispiel 4, wobei die Fluidleitung durch eine Kammerwand der Vakuumkammer hindurch erstreckt ist.

Beispiel 6 ist die Verdampfungsanordnung gemäß einem der Beispiele 1 bis 5, ferner aufweisend: eine Druckkammer, welche beispielsweise zumindest einen Vorratstiegel des mehr als einen Vorratstiegels bereitstellt oder in welcher der eine Vorratstiegel angeordnet ist, wobei beispielsweise die Druckkammer ein Tiegelbehälter des Vorratstiegels ist (dann auch als Druckbehälter oder Druckkörper bezeichnet), wobei beispielsweise der Vorratstiegel den Druckkörper aufweist oder daraus gebildet ist.

Beispiel 7 ist die Verdampfungsanordnung gemäß einem der Beispiele 1 bis 6, wobei der Vorratstiegel (beispielsweise der die Druckkammer aufweist) einen nach oben hermetisch abgeschlossenen Tiegelinnenraum aufweist und beispielsweise diesem gegenüberliegend eine Durchgangsöffnung, welche beispielsweise dessen Tiegelinneres freilegt und/oder mit dem Verdampfungstiegel fluidleitend gekoppelt ist.

Beispiel 8 ist die Verdampfungsanordnung gemäß einem der Beispiele 1 bis 7, wobei der Vorratstiegel (beispielsweise der in der Druckkammer angeordnet ist) und/oder der Verdampfungstiegel zwei einander gegenüberliegende Seiten aufweisen, von denen jede Seite eine Durchgangsöffnung in aufweist, welche deren Tiegelinneren freilegt und/oder von denen eine Durchgangsöffnung mit dem Vorratstiegel fluidleitend gekoppelt ist und/oder von denen eine andere Durchgangsöffnung mit einer Dampfführung fluidleitend gekoppelt ist.

Beispiel 9 ist die Verdampfungsanordnung gemäß einem der Beispiele 1 bis 8, ferner aufweisend: eine Gasverlagerungsvorrichtung, welche beispielsweise mit dem oder jedem Vorratstiegel (z.B. dessen Tiegelinneren) fluidleitend gekoppelt ist (z.B. mittels der Druckkammer) und eingerichtet ist, diesem ein Gas zuzuführen und/oder zu entziehen (z.B. zum Bilden eines Überdrucks in dem Vorratstiegel), und/oder welche beispielsweise eingerichtet ist, in dem Vorratstiegel einen Überdruck und/oder Unterdruck bereitzustellen.

Beispiel 10 ist die Verdampfungsanordnung gemäß einem der Beispiele 1 bis 9, ferner aufweisend: eine Materialnachfüllungsvorrichtung, welche eingerichtet ist, einem Vorratstiegel des einen oder mehr als einen Vorratstiegels ein zu verdampfendes Material zuzuführen.

Beispiel 11 ist die Verdampfungsanordnung gemäß einem der Beispiele 1 bis 10, ferner aufweisend: eine zusätzliche Druckkammer, in welcher die Materialnachfüllungsvorrichtung angeordnet ist.

Beispiel 12 ist die Verdampfungsanordnung gemäß einem der Beispiele 1 bis 11, ferner aufweisend: eine Sensorvorrichtung, welche eingerichtet ist, eine Temperatur des Verdampfungstiegels und/oder einen Füllstand des Verdampfungstiegels zu erfassen.

Beispiel 13 ist die Verdampfungsanordnung gemäß einem der Beispiele 1 bis 12, ferner aufweisend: eine Steuervorrichtung, welche beispielsweise eingerichtet ist, eine Verdampfungsrate des Verdampfungstiegels zu steuern und/oder zu regeln mittels Stellens einer Temperatur des Verdampfungstiegels und/oder eines Füllstands des Verdampfungstiegels; und/oder welche beispielsweise eingerichtet ist, den Füllstand zu steuern und/oder zu regeln mittels Stellens eines Gasdrucks in dem Vorratstiegel und/oder in dem Verdampfungstiegel.

Beispiel 14 ist die Verdampfungsanordnung gemäß einem der Beispiele 1 bis 13, ferner aufweisend: eine Dampfführung, welche einen Dampfströmungskanal aufweist, der mit dem Verdampfungstiegel gekoppelt ist und entlang eines gekrümmten und/oder abgewinkelten Pfads verläuft.

Beispiel 15 ist eine Prozessieranordnung, aufweisend: die Verdampfungsanordnung gemäß einem der Beispiele 1 bis 14, eine Transportvorrichtung zum Transportieren eines Substrats an dem Verdampfungstiegel, an einer Dampfaustrittsöffnung des Verdampfungstiegels und/oder an einer Dampfaustrittsöffnung der Dampfführung vorbei.

Beispiel 16 ist ein Verfahren, aufweisend: Ermitteln (z.B. Auslesen) eines Ist-Zustandes einer Regelgröße (z.B. Füllstand und/oder Tiegeltemperatur), welche eine Verdampfungsrate eines Verdampfungsguts aus einem Verdampfungstiegel heraus und/oder dessen Füllstand repräsentiert; Ansteuern eines (z.B. druckverändernden) Stellglieds (z.B. einer Gasverlagerungsvorrichtung und/oder einer Heizvorrichtung), welche ein fließendes Verlagern des Verdampfungsguts zwischen dem Verdampfungstiegel und einem Vorratstiegel beeinflusst, auf Grundlage eines Vergleichs des Ist-Zustandes mit einem Soll-Zustand der Regelgröße.

Beispiel 17 ist das Verfahren gemäß Beispiel 16, wobei das eine oder mehr als eine Stellglied ein erstes Stellglied aufweist, welches einen Arbeitspunkt der Gasverlagerungsvorrichtung beeinflusst, und/oder ein zweites Stellglied aufweist, welches einen Arbeitspunkt der Heizvorrichtung beeinflusst, wobei beispielsweise der Arbeitspunkt der Heizvorrichtung deren Leistungsaufnahme (und/oder das Zuführen von thermischer Energie zu dem Verdampfungstiegel und/oder zu dem Vorratstiegel) beeinflusst; wobei beispielsweise der Arbeitspunkt der Gasverlagerungsvorrichtung das Zuführen und/oder Entziehen von Gas (z.B. Argon) zu/von dem Vorratstiegel (z.B. dessen Tiegelinnenraum) beeinflusst; wobei beispielsweise das Beeinflussen des Arbeitspunkts der Gasverlagerungsvorrichtung nach dem Zuführen der thermischen Energie erfolgt, so dass die auf das flüssige Verdampfungsgut wirkende Druckdifferenz das fließende Verlagern des Verdampfungsgut bewirkt, wobei beispielsweise die Druckdifferenz auf das Verdampfungsgut entlang des fließendes Verlagerns (z.B. entlang der fluidleitenden Kopplung) zwischen dem Verdampfungstiegel und dem Vorratstiegel einwirkt, wobei die Druckdifferenz die Differenz zwischen einem auf das Verdampfungsgut in dem Verdampfungstiegel einwirkenden ersten Druck (z.B. Kammerdruck) und einem auf das Verdampfungsgut in dem Vorratstiegel einwirkenden zweiten Druck (z.B. Ausgleichsdruck) ist.

Beispiel 18 ist ein Verfahren (z.B. das Verfahren gemäß Beispiel 17), wobei das Verfahren aufweist, eine oder mehr als eine (z.B. alle) der folgenden Sequenzen durchzuführen: eine Inbetriebnahmesequenz, eine Außerbetriebnahmesequenz, und/oder eine Notabschaltungssequenz; wobei die Inbetriebnahmesequenz aufweist: eine erste Phase, in der das Stellglied derart angesteuert wird, dass die Leistungsaufnahme der Haltevorrichtung vergrößert wird, und in der der erste Druck und/oder der zweite Druck ein Unterdruck sind; und eine zweite Phase nach der ersten Phase, wobei in der zweiten Phase der zweite Druck größer ist als der erste Druck, so dass das Verdampfungsgut aus dem Vorratstiegel in den Verdampfungstiegel fließt; wobei die Außerbetriebnahmesequenz aufweist, dass der zweite Druck größer ist als der erste Druck, der ein Unterdruck ist, und verringert wird, so dass das Verdampfungsgut aus dem Verdampfungstiegel in den Vorratstiegel fließt, und dass das Stellglied derart angesteuert wird, dass die Leistungsaufnahme der Haltevorrichtung verringert wird (z.B. wenn der zweite Druck und der erste Druck ein Unterdruck sind); wobei die Notabschaltungssequenz aufweist, dass das Stellglied derart angesteuert wird, dass der erste Druck, der ein Unterdruck ist, vergrößert wird und/oder auf Atmosphärendruck gebracht wird, so dass das Verdampfungsgut aus dem Verdampfungstiegel in den Vorratstiegel fließt, und so dass die Leistungsaufnahme der Heizvorrichtung verringert oder auf null gebracht wird (z.B. wenn der zweite Druck größer ist als der erste Druck und/oder der erste Druck ein Unterdruck ist), und so dass nach dem Verändern der Stellgröße der erste Druck und der zweite Druck auf Atmosphärendruck gebracht sind.

Beispiel 19 ist eine Steuervorrichtung (z.B. die Steuervorrichtung gemäß Beispiel 13), aufweisend einen oder mehr als einen Prozessor, der eingerichtet ist zum Durchführen des Verfahrens gemäß einem der Beispiele 16 bis 18.

Beispiel 20 ist ein Verfahren, aufweisend: Zuführen von thermischer Energie zu einem Verdampfungstiegel, welcher einem ersten Druck ausgesetzt ist; Zuführen von thermischer Energie zu einem Verdampfungsgut innerhalb eines Vorratstiegels, welcher mit dem Verdampfungstiegel fluidleitend gekoppelt ist, wobei das Verdampfungsgut in dem Vorratstiegel einem zweiten Druck ausgesetzt ist; Verändern einer Druckdifferenz zwischen dem ersten Druck und dem zweiten Druck (beispielsweise nachdem der Verdampfungstiegel und/oder der Vorratstiegel auf eine Temperatur oberhalb einer Schmelztemperatur des Verdampfungsguts gebracht sind und/oder nach dem vollständigen Schmelzen des Verdampfungsguts in dem Vorratstiegel), so dass die auf eine Schmelze des Verdampfungsguts (d.h. das flüssige bzw. geschmolzene Verdampfungsgut) wirkende Druckdifferenz eine Verlagerung der Schmelze zwischen dem Vorratstiegel und dem Verdampfungstiegel bewirkt, z.B. so dass die Schmelze aus dem Vorratstiegel heraus in den Verdampfungstiegel hinein fließt oder andersherum, wobei optional das Verändern der Druckdifferenz den zweiten Druck vergrößert; wobei optional das Verändern der Druckdifferenz den zweiten Druck verkleinert, wobei optional das Verändern der Druckdifferenz den ersten Druck vergrößert.

Beispiel 21 ist das Verfahren gemäß Beispiel 20, wobei das Zuführen von thermischer Energie zu dem Verdampfungsgut innerhalb eines Vorratstiegels ein Schmelzen des Verdampfungsguts bewirkt und/oder die Schmelze oberhalb der Schmelztemperatur hält.

Beispiel 22 ist das Verfahren gemäß Beispiel 20 oder 21, ferner aufweisend: thermisches Verdampfen des (flüssigen) Verdampfungsguts aus dem Verdampfungstiegel heraus (so dass die Schmelze des Verdampfungsguts verbraucht wird), Verändern der Druckdifferenz derart, dass eine Absinken eines Füllstands der Schmelze in dem Verdampfungstiegel aufgrund des Verdampfens gehemmt wird (z.B. indem die Schmelze aus dem Vorratstiegel heraus in den Verdampfungstiegel hinein fließt).

Beispiel 23 ist das Verfahren gemäß einem der Beispiele 20 bis 22, ferner aufweisend: Beschichten eines Substrats mit dem verdampften Verdampfungsgut.

Beispiel 24 ist das Verfahren gemäß einem der Beispiele 20 bis 23, wobei vor dem Verändern der Druckdifferenz: beispielsweise der erste Druck ein Unterdruck ist und/oder der zweite Druck (z.B. ein Überdruck ist) größer als der erste Druck ist, z.B. um mindestens einen Differenzdruck und/oder 0,1 bar (z.B. gemäß einer Verdampfungssequenz oder einer Außerbetriebnahmesequenz); oder beispielsweise der erste Druck ein Unterdruck ist und/oder der zweite Druck (z.B. ein Unterdruck ist) von dem ersten Druck abweicht um weniger als der Differenzdruck und/oder 0,1 bar (z.B. gemäß der Inbetriebnahmesequenz); und/oder wobei das Verändern der Druckdifferenz: beispielsweise den zweiten Druck vergrößert, zumindest um mindestens den Differenzdruck und/oder 0,1 bar (z.B. gemäß der Verdampfungssequenz oder der Inbetriebnahmesequenz); oder beispielsweise den zweiten Druck verkleinert, z.B. um mindestens den Differenzdruck und/oder 0,1 bar (z.B. gemäß der Außerbetriebnahmesequenz); oder beispielsweise den ersten Druck vergrößert, z.B. um mindestens den Differenzdruck und/oder 0,1 bar (z.B. gemäß der Notabschaltungssequenz), wobei der Differenzdruck beispielsweise dem Schweredruck der Schmelze entspricht.

Beispiel 25 ist ein Verfahren, aufweisend: Zuführen von thermischer Energie zu einem flüssigen Verdampfungsgut, welches in einem Verdampfungstiegel und/oder in einem Vorratstiegel angeordnet ist, welche fluidleitend miteinander gekoppelt sind; wobei in dem Verdampfungstiegel (z.B. dessen Tiegelinnenraum) ein erster Druck und in dem Vorratstiegel (z.B. dessen Tiegelinnenraum) ein zweiter Druck bereitgestellt sind; Verändern einer Druckdifferenz zwischen dem ersten Druck und dem zweiten Druck nach dem Zuführen von thermischer Energie, so dass die auf das flüssige Verdampfungsgut wirkende Druckdifferenz einen Fluss (fließendes Verlagern) des flüssigen Verdampfungsguts zwischen dem Vorratstiegel und dem Verdampfungstiegel bewirkt.

Beispiel 26 ist ein Gegenstand gemäß einem der Beispiele 1 bis 25, wobei die Druckdifferenz dem Schweredruck der Schmelze zwischen der Vorratskammer und der Verdampfungskammer entspricht.

## Patentansprüche

1. Verdampfungsanordnung (100 bis 400, 550), aufweisend:
• einen Verdampfungstiegel (102);
• einen Vorratstiegel (112), welcher mit dem Verdampfungstiegel (102) fluidleitend gekoppelt ist zum Austauschen eines zu verdampfenden Verdampfungsguts zwischen dem Vorratstiegel (112) und dem Verdampfungstiegel (102);
• eine Vakuumkammer (802), in welcher der Verdampfungstiegel (102) angeordnet ist, wobei der Vorratstiegel (112) außerhalb der Vakuumkammer (802) angeordnet ist.

2. Verdampfungsanordnung (100 bis 400, 550) gemäß Anspruch 1, wobei der Verdampfungstiegel (102) und der Vorratstiegel (112) höhenversetzt zueinander angeordnet sind.

3. Verdampfungsanordnung (100 bis 400, 550) gemäß Anspruch 1 oder 2, ferner aufweisend:
eine Heizvorrichtung (204), welche eingerichtet ist, dem Vorratstiegel (112) und/oder dem Verdampfungstiegel (102) thermische Energie zuzuführen.

4. Verdampfungsanordnung (100 bis 400, 550) gemäß Anspruch 3, wobei der Vorratstiegel (112) einen Druckkörper aufweist.

5. Verdampfungsanordnung (100 bis 400, 550) gemäß einem der Ansprüche 1 bis 4, ferner aufweisend:
eine Gasverlagerungsvorrichtung, welche eingerichtet ist, in dem Vorratstiegel (112) einen Überdruck und/oder Unterdruck bereitzustellen.

6. Verdampfungsanordnung (100 bis 400, 550) gemäß einem der Ansprüche 1 bis 5, ferner aufweisend:
• einen zusätzlichen Vorratstiegel (122), welcher mit dem Vorratstiegel (112) fluidleitend gekoppelt ist, und
• eine Materialnachfüllungsvorrichtung (206), welche eingerichtet ist, dem zusätzlichen Vorratstiegel (122) ein zu verdampfendes Material zuzuführen.

7. Verdampfungsanordnung (100 bis 400, 550) gemäß einem der Ansprüche 1 bis 6, ferner aufweisend:
eine Sensorvorrichtung, welche eingerichtet ist, eine Temperatur des Verdampfungstiegels (102) und/oder einen Füllstand des Verdampfungstiegels (102) zu erfassen.

8. Verdampfungsanordnung (100 bis 400, 550) gemäß einem der Ansprüche 1 bis 7, ferner aufweisend:
eine Steuervorrichtung (410), welche eingerichtet ist,
• eine Verdampfungsrate des Verdampfungstiegels (102) zu steuern und/oder zu regeln mittels Stellens einer Temperatur des Verdampfungstiegels (102) und/oder eines Füllstands des Verdampfungstiegels (102); und/oder
• den Füllstand des Verdampfungstiegels (102) zu steuern und/oder zu regeln mittels Stellens eines Gasdrucks (94) in dem Vorratstiegel (112).

9. Verdampfungsanordnung (100 bis 400, 550) gemäß einem der Ansprüche 1 bis 8, ferner aufweisend:
eine Dampfführung (212), welche einen Dampfströmungskanal aufweist, der mit dem Verdampfungstiegel (102) gekoppelt ist und entlang eines gekrümmten und/oder abgewinkelten Pfads verläuft.

10. Prozessieranordnung (500), aufweisend:
• die Verdampfungsanordnung (100 bis 400, 550) gemäß einem der Ansprüche 1 bis 9,
• eine Transportvorrichtung (502) zum Transportieren eines Substrats an dem Verdampfungstiegel (102) vorbei.

11. Verfahren, aufweisend:
• Zuführen von thermischer Energie zu einem Verdampfungstiegel (102), welcher einem ersten Druck (91) ausgesetzt ist;
• Zuführen von thermischer Energie zu einem Verdampfungsgut innerhalb eines Vorratstiegels (112), welcher mit dem Verdampfungstiegel (102) fluidleitend gekoppelt ist, wobei das Verdampfungsgut in dem Vorratstiegel (112) einem zweiten Druck (94) ausgesetzt ist;
• Verändern einer Druckdifferenz zwischen dem ersten Druck (91) und dem zweiten Druck (94), so dass die auf eine Schmelze des Verdampfungsguts wirkende Druckdifferenz einen Fluss der Schmelze zwischen dem Vorratstiegel (112) und dem Verdampfungstiegel (102) bewirkt.

12. Verfahren gemäß Anspruch 11, wobei vor dem Verändern der Druckdifferenz der erste Druck (91) ein Unterdruck ist und der zweite Druck (94) größer ist als der erste Druck (91) um mindestens einen Schweredruck der Schmelze.

13. Verfahren gemäß Anspruch 11 oder 12, wobei vor dem Verändern der Druckdifferenz der erste Druck (91) ein Unterdruck ist und der zweite Druck (94) vom den ersten Druck abweicht um weniger als einen Schweredruck der Schmelze.

14. Verfahren, aufweisend:
• Ermitteln eines Ist-Zustandes einer Regelgröße (306), welche eine Verdampfungsrate eines Verdampfungsguts (220) aus einem Verdampfungstiegel (102) repräsentiert;
• Ansteuern eines Stellglieds, welche ein fließendes Verlagern des Verdampfungsguts zwischen dem Verdampfungstiegel (102) und einem Vorratstiegel (112) beeinflusst, auf Grundlage eines Vergleichs des Ist-Zustandes mit einem Soll-Zustand der Regelgröße.

15. Steuervorrichtung (410), aufweisend einen oder mehr als einen Prozessor, der eingerichtet ist zum Durchführen des Verfahrens gemäß Anspruch 14.
